Europäisches Patentamt

European Patent Office

Office européen des brevets

(11) Veröffentlichungsnummer: **0 335 104**
**A2**

## (12) EUROPÄISCHE PATENTANMELDUNG

(21) Anmeldenummer: 89103004.1

(22) Anmeldetag: 21.02.89

(51) Int. Cl.4: **H04B 9/00**

(30) Priorität: 31.03.88 DE 3811028

(43) Veröffentlichungstag der Anmeldung:
04.10.89 Patentblatt 89/40

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Karstensen, Holger, Dr.**
**Wörthstrasse 35**
**D-8000 München 80(DE)**
Erfinder: **Klement, Ekkehard, Dr.**
**Akilindastrasse 31**
**D-8032 Gräfelfing(DE)**

(54) Vorrichtung zum optischen Verbinden eines oder mehrerer optischer Sender mit einem oder mehreren optischen Detektoren eines oder mehrerer integrierter Schaltkreise.

(57) Es sollen mit möglichst wenig baulichem Aufwand und mit großer Präzision sowohl externe optische Verbindungen von verschiedenen integrierten Schaltkreisen, insbesondere von Rechnerchips, als auch interne optische Verbindungen bei einzelnen integrierten Schaltkreisen sowohl solche externen und internern optischen Verbindungen in Kombination hergestellt werden können.

Eine Vorrichtung, welche dieses leistet, weist ein Substrat (Su) auf, auf dem die integrierten Schaltkreise (IC), optischen Sender (oS) und optischen Detektoren (oD) in Form von Bausteinen fixiert sind, wobei auf dem Substrat ein Abstandshalter (Ah) aufgebracht ist und der Abstandshalter von einem Deckkörper (DK) abgedeckt ist, und wobei an dem Abstandshalter oder/und dem Deckkörper eine optische Einrichtung (oE) zum Zuleiten des von einem optischen Sender (oS) ausgesandten Lichts zu einem oder mehreren optischen Detektoren (oD) angebracht ist.

Anwendung zum optischen Verbinden von Rechnerchips

FIG 4

# Vorrichtung zum optischen Verbinden eines oder mehrerer optischer Sender mit einem oder mehreren optischen Detektoren eines oder mehrerer integrierter Schaltkreise

Die Erfindung betrifft eine Vorrichtung zum optischen Verbinden eines oder mehrerer optischer Sender mit einem oder mehreren optischen Detektoren eines oder mehrerer integrierter Schaltkreise.

Aus Appl. Optics, Vol. 26, Nr. 20, 15. Okt. 1987, S. 4377-4384 ist eine Vorrichtung zum optischen Verbinden mehrerer, einem gemeinsamen integrierten Schaltkreis zugeordneter optischer Sender mit mehreren optischen Detektoren dieses Schaltkreises bekannt, bei dem eine optische Einrichtung zum Zuleiten des von einem optischen Sender ausgesandten Lichts zu mehreren optischen Detektoren aus einem Hologramm besteht, das oberhalb der Sender und dem integrierten Schaltkreis angeordnet ist, dem das von einem Sender ausgesandte Licht zugeleitet ist, und das dieses zugeleitete Licht auf bestimmte optische Detektoren auf dem integrierten Schaltkreis verteilt. Näheres über die Fixierung der Detektoren, des Hologramms und des integrierten Schaltkreises relativ zueinander geht aus dieser Druckschrift nicht hervor.

Aus Appl. Optics, Vol. 26, Nr. 17, 1. Sept. 1987, S. 3649-3654 ist eine Vorrichtung zum optischen Verbinden mehrerer optischer Sender mit mehreren optischen Detektoren bekannt, bei der die optischen Sender auf einem Substrat angeordnet und von einer transparenten, schichtförmigen Ausrichtungsschablone abgedeckt sind. Zwischen dieser Schablone und einer Schicht aus Silizium ist als eine optische Einrichtung zum Zuleiten des von einem optischen Sender ausgesandten Lichts zu einem oder mehreren optischen Detektoren eine Fresnelsche Phasenplattenlinse angeordnet, durch die das von den optischen Sendern ausgesandte Licht, das die Schablone und die Schicht aus Silizium Ed 1 Sti/30.03.1988 durchsetzt, den optischen Detektoren zugeleitet ist, die auf der Schicht aus Silizium auf der von der Linse und den Sendern abgekehrten Seite angeordnet sind.

Aufgabe der vorliegenden Erfindung ist es, eine Vorrichtung zum optischen Verbinden eines oder mehrerer optischer Sender mit einem oder mehreren optischen Detektoren eines oder mehrerer integrierter Schaltkreise zu schaffen, bei welchem mit möglichst wenig baulichem Aufwand und mit großer Präzision sowohl externe optische Verbindungen von verschiedenen integrierten Schaltkreisen, insbesondere von Rechnerchips, als auch interne optische Verbindungen bei einzelnen integrierten Schaltkreisen sowie solche externen und internen optischen Verbindungen in Kombination herstellbar sind.

Diese Aufgabe wird durch die im Anspruch 1 angegebenen Merkmale gelöst.

Durch diese Lösung können mit im wesentlichen nur drei Bauelementen interne und externe optische Verbindungen in oder zwischen integrierten Halbleiterchips auf einfache Weise und mit hoher Präzision hergestellt werden, wobei ein besonderer Vorteil darin besteht, daß externe und interne optische Verbindungen in Kombination hergestellt werden können.

Damit die erzielbare hohe Präzision dauerhaft bleibt, ist es zweckmäßig, die erfindungsgemäße Vorrichtung so zu gestalten, wie es im Anspruch 2 angegeben ist, wobei das im Anspruch 3 angegebene Silizium von besonderem Vorteil ist, weil dieses Material anisotrop ätzbar ist und dadurch eine einfache Herstellung von schrägen Seitenflächen ermöglicht, die bei bestimmten Ausführungsformen der Erfindung erforderlich sind.

Eine besonders zweckmäßige Ausgestaltung des Abstandshalters der erfindungsgemäßen Vorrichtung, der mit herkömmlichen lithografischen Verfahren einfach und mit hoher Genauigkeit herstellbar und darüber hinaus universell einsetzbar ist, geht aus dem Anspruch 4 hervor.

Für die Herstellung externer optischer Verbindungen zwischen verschiedenen optischen Schaltkreisen, beispielsweise zwischen Rechnerchips zur Ermöglichung eines Datenaustausches zwischen diesen Chips, ist eine Ausgestaltung der erfindungsgemäßen Vorrichtung vorteilhaft, die im Anspruch 5 angegeben ist.

Die dort angegebene Wellenleiterstruktur besteht bevorzugterweise gemäß Anspruch 6 aus einem oder mehreren Streifenwellenleitern, die vorteilhafterweise gemäß Anspruch 7 aus Glas bestehen, weil dann die Struktur sehr einfach mit Hilfe eines herkömmlichen lithografischen Prozesses aus einer ebenfalls einfach herstellbaren Glasschicht herausgeätzt werden kann.

Die Ankopplung optischer Sender und optischer Detektoren an die Wellenleiterstruktur kann auf verschiedene Weise vorgenommen werdne, wobei bevorzgute Möglichkeiten aus den Ansprüche 8 bis 16 hervorgehen.

Bei den im Anspruch 9 und im Anspruch 14 angegebenen Ausführungsformen ist eine Aussparung im Deckkörper notwendig. Eine solche Aussparung im Deckkörper, die in einer fensterartigen Öffnung bestehen kann, kann aber auch bei anderen Ausführungsformen vorgesehen sein, bei denen alle auf dem Substrat fixierten Bausteine niedriger als der Abstandshalter sind, so daß eine Aussparung im Deckkörper nicht erforderlich wäre.

Der Anspruch 17 ist konkret auf die neuartige Vorrichtung zur Bildung externer optischer Verbindungen gerichtet, die vorteilhafterweise so ausgestaltet ist, wie es im Anspruch 18 angegeben ist. Gerade bei dieser letztgenannten Vorrichtung können neben den externen optischen Verbindungen auf einfache Weise auch interne optische Verbindungen gleichzeitig realisiert werden.

Eine solche interne optische Verbindung ist bei einer erfindungsgemäßen Vorrichtung zweckmäßigerweise so ausgebildet, wie es im Anspruch 19 angegeben ist. Bevorzugte Ausgestaltungen dieser Vorrichtung gehen aus den Ansprüchen 20 und 21 hervor.

Die Vorrichtungen nach den Ansprüchen 19 bis 21 sind insbesondere für eine Vorrichtung nach Anspruch 18 geeignet, wenn externe und interne Verbindungen zwischen und in integrierten Schaltkreisen gleichzeitig herzustellen sind.

Eine vorteilhafte Vorrichtung, bei welcher externe und interne optische Verbindungen realisiert oder realisierbar sind, geht aus dem Anspruch 22 hervor.

Die Erfindung wird anhand der Figuren in der nun folgenden Beschreibung beispielhaft näher erläutert. Von den Figuren zeigen:

Figur 1 einen Schnitt durch eine Ausführungsform einer Vorrichtung, bei welcher zwei Silizium-Chips mit integrierten Schaltkreisen durch eine optische Parallelverbindung extern miteinander verbunden sind,

Figur 2 einen Schnitt durch eine andere Ausführungsform der Vorrichtung nach Figur 1,

Figur 3 einen Schnitt durch eine Ausführungsform einer Vorrichtung, bei welcher ein optischer Detektor, der einem Silizium-Chip mit einer integrierten Schaltung zugeordnet ist, optisch mit Detektoren dieses Chips verbunden ist, so daß eine interne optische Verbindung gegeben ist,

Figur 4 einen Schnitt durch eine Ausführungsform einer Vorrichtung, bei welcher Silizium-Chips mit integrierten Schaltkreisen extern optisch verbunden sind, und bei welcher für jeden Chip auch eine interne optische Verbindung realisiert ist, und

Figur 5 eine Draufsicht auf die Ausführungsform nach Figur 4, wobei der Deckkörper und eine Schicht des Abstandshalters weggelassen sind.

In den Figuren sind gleiche oder einander entsprechende Teile mit gleichen Bezugszeichen versehen.

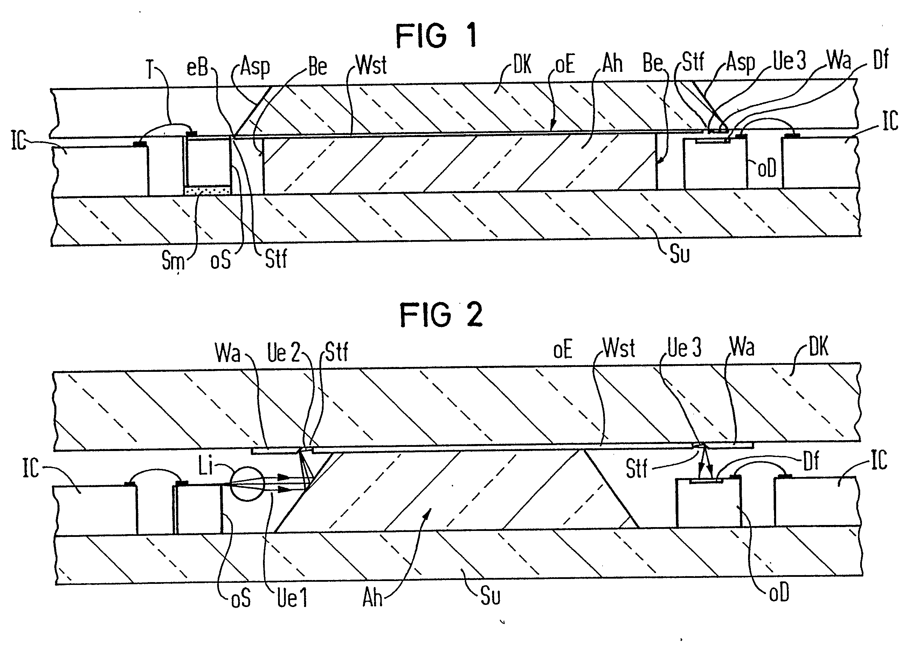

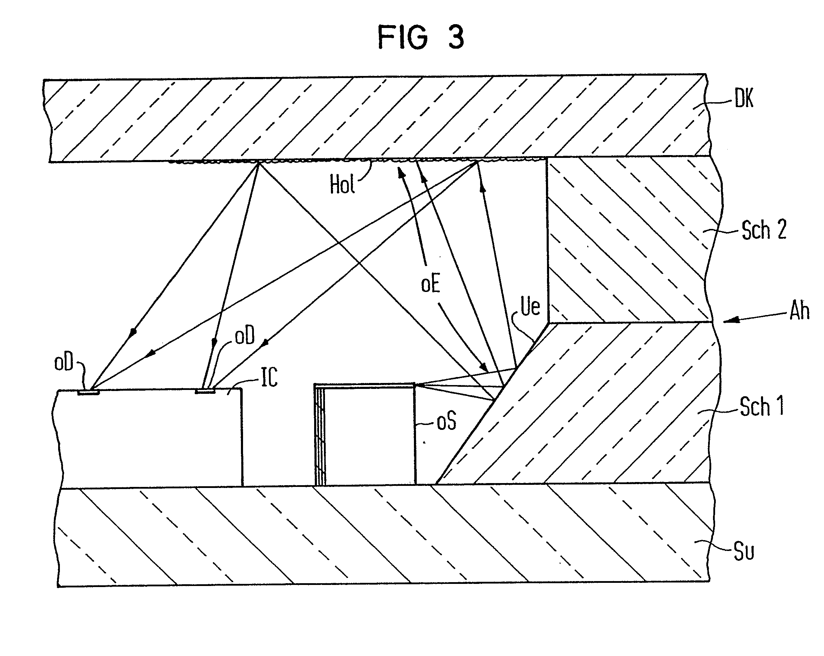

Bei der Ausführungsform nach Figur 1 bestehen das Substrat Su, der Abstandshalter Ah und der Deckkörper DK jeweils aus einer Schicht aus Silizium, deren Schichtdicke beispielsweise 300 μm bis 1000 μm beträgt. Auf dem Substrat Su sind zu beiden Seiten des Abstandshalters Ah jeweils ein Silizium-Chip mit einem integrierten Schaltkreis IC angeordnet, wobei auf der linken Seite ein dem auf dieser Seite angeordneten integrierten Schaltkreis IC zugeordneter optischer Sender oS in Form eines senkrecht zur Zeichenebene verlaufenden Laserdiodenarrays und auf der rechten Seite ein dem auf dieser anderen Seite angeordneten integrierten Schaltkreis IC zugeordneter optischer Detektor oD in Form eines senkrecht zur Zeichenebene verlaufenden Fotodetektorarrays auf dem Substrat Su angeordnet ist. Der mit dem zugeordneten integrierten Schaltkreis IC elektrisch verbundene optische Sender oS wird von diesem Schaltkreis gesteuert, während der optische Detektor oD elektrisch mit dem ihm zugeordneten integrierten Schaltkreis IC verbunden ist und diesen steuert. In der Figur 1 sind wie in den Figuren 2, 4 und 5 die optischen Sender oS und optischen Detektoren oD von den Halbleiterchips getrennte Bausteine. Sie könnten aber auch mit auf den Chips integriert sein, so wie es bei den Detektoren oD der Figur 3 der Fall ist.

Der Abstandshalter Ah ist zweckmäßigerweise eine Schicht, in der Bereiche Be ausgespart sind, in denen die Bausteine auf dem Substrat Su fixiert sind, beispielsweise durch Kleben. Diese Bereiche Be können leicht durch Ätzen hergestellt werden.

Der Abstandshalter Ah ist von dem Deckkörper DK abgedeckt. Zwischen dem Deckkörper DK und dem Abstandshalter Ah ist eine Wellenleiterstruktur Wst angeordnet, die beispielsweise aus parallelen Streifenwellenleitern aus Glas bestehen kann, von denen jeder von einer Laserdiode des optischen Senders oS zu einem zugeordneten Fotodetektor des optischen Detektors oD führt.

Diese Wellenleiterstruktur Wst kann auf einfache Weise dadurch hergestellt werden, daß auf den Abstandshalter Ah oder den Deckkörper DK eine Glasschicht von beispielsweise einer Dicke von 8 μm bis 50 μm aufgebracht wird und aus dieser Schicht mit Hilfe eines herkömmlichen fotolithografischen Prozesses die gewünschte Wellenleiterstruktur Wst geätzt wird. Das Anbringen der Glasschicht kann beispielsweise mit Hilfe eines bekannten CVD-Verfahrens erfolgen. Die Herstellung der Wellenleiterstruktur Wst ist somit einfach und unproblematisch.

Das Ein- und Auskoppeln von Licht in oder aus der Wellenleiterstruktur Wst kann auf verschiedene Weise erfolgen. Bei der Ausführungsform nach Figur 1 strahlt der optische Sender oS sein Licht in der Ebene der Streifenwellenleiterstruktur Wst ab. Der lichtemittierende Bereich eB dieses Senders oS liegt einer Stirnfläche Stf eines Wellenleiters der Streifenwellenleiterstruktur Wst gegenüber, durch die das vom Sender oS ausgesandte Licht in die Wellenleiterstruktur Wst eingekoppelt wird. Um den lichtemittierenden Bereich eB des optischen Senders oS auf die Höhe der Wellenleiterstruktur Wst zu bringen, kann ein Sockel Sm verwendet werden, der geeignet bemessen ist und auf dem der Sender oS befestigt wird. Um Platz für Teile T des optischen Senders oS zu schaffen, die oberhalb des lichtemittierenden Bereichs eB liegen, beispielsweise für Kontakte und elektrische Verbindungen, ist im Bereich des optischen Senders eine Aussparung Asp vorgesehen, in die diese Teile T ragen. Diese Aussparung Asp kann beispielsweise in Form eines Fensters im Deckkörper ausgebildet sein und durch Ätzen, beispielsweise durch Vorzugsätzen von Silizium, hergestellt werden. Solche Aussparungen Asp können aber auch an anderen Stellen des Deckkörpers DK vorgesehen sein, beispielsweise überall dort, wo Bausteine mit integrierten Schaltkreisen auf dem Substrat Su fixiert sind.

Die Ankopplung des optischen Detektors oD erfolgt bei der Ausführungsform nach Figur 1 über ein Umlenkelement Ue3, welches das durch eine Stirnfläche Stf eines Wellenleiters der Wellenleiterstruktur Wst ausgekoppelte Licht zu einem Detektorfen ster Df umlenkt, das dem Deckkörper DK zugekehrt ist. Dieses Umlenkelement Ue3 kann beispielsweise aus einer schrägen Stirnfläche eines kurzen Wellenleiterabschnitts Wa bestehen, der an der Unterseite des Deckkörpers DK so fixiert ist, daß das Licht aus der Wellenleiterstruktur Wst auf die schräge Stirnfläche fällt.

Der optische Detektor oD könnten auch so angeordnet sein, daß sein Detektorfenster Df einer Stirnfläche Stf eines Wellenleiters der Wellenleiterstruktur Wst gegenüberliegt und das durch diese Stirnfläche ausgekoppelte Licht direkt dem Detektorfenster Df zugeleitet wird. In diesem Fall wäre die bei der Ausführungsform nach Figur 1 auf der Detektorseite vorgesehene Aussparung Asp unerläßlich.

Wird für die Ein- und Auskopplung eine Strahlumlenkung verwendet, kann die Dicke des Abstandshalters Ah größer als die maximale Höhe der auf dem Substrat beispielsweise durch Kleben befestigten Bausteine gemacht werden. Aussparungen im Deckkörper DK sind in diesem Fall nicht erforderlich.

Die Figur 2 zeigt eine solche Ausführungsform, bei welcher die Ein- und Auskopplung durch Umlenkung erfolgt. Diese Ausführungsform nach Figur 2 unterscheidet sich von der Ausführungsform nach Figur 1 lediglich dadurch, daß auch die Einkopplung des Lichts in die Wellenleiterstruktur Wst durch Umlenkung erfolgt und daß im Deckkörper DK keine Aussparungen vorgesehen sind.

Das von dem optischen Sender oS parallel zur Ebene der Wellenleiterstruktur Wst und divergent abgestrahlte Licht wird durch eine Sammellinse Li und zwei Umlenkelemente Ue1 und Ue2 auf eine Stirnfläche Stf eines Wellenleiters der Wellenleiterstruktur Wst konzentriert. Die Linse Li, die auf einem auf dem Substrat Su fixierten Sockel befestigt sein kann, der nicht dargestellt ist, kann im Fall des Laserdiodenarrays ein mit seiner Längsrichtung senkrecht zur Zeichenebene angeordneter Glasstab mit kreisförmigem Querschnitt sein. Das erste Umlenkelement Ue1 besteht zweckmäßigerweise aus einer schrägen Sei tenfläche des Abstandshalters Ah, die das Licht in Richtung zum anderen Umlenkelement Ue2 umlenkt. Die schräge Seitenfläche kann durch anisotropes Ätzen der den Abstandshalter Ah bildenden Siliziumschicht hergestellt werden. Das andere Umlenkelement Ue2 ist durch eine schräge Stirnfläche eines kurzen Wellenleiterabschnitts Wa gebildet, der so an der Unterseite des Deckkörpers DK befestigt ist, daß die schräge Stirnfläche Ue2 das zugeleitete Licht auf die Stirnfläche Stf des Wellenleiters der Wellenleiterstruktur Wst umlenkt.

Bei der Ausführungsform nach Figur 3 besteht der Abstandshalter Ah aus zwei Siliziumschichten Sch1 und Sch2. Die untere Siliziumschicht Sch1 weist eine als Umlenkelement Ue dienende schräge Seitenfläche auf, die durch anisotropes Ätzen hergestellt werden kann.

Das vom optischen Sender oS, beispielsweise einer Laserdiode, in Richtung des Umlenkelements Ue ausgesandte Licht wird von diesem Umlenkelement Ue zu einer Lichtverteilungseinrichtung Hol umgelenkt, die an der Unterseite des Deckkörpers DK angebracht oder ausgebildet ist und die das zugeleitete Licht auf optische Detektoren oD verteilt, die auf einem Halbleiterchip mit integriertem Schaltkreis IC, beispielsweise in Form von Fotodetektoren, integriert sind. Die Lichtverteilungseinrichtung Hol kann beispielsweise ein Hologramm sein.

Die Ausführungsform nach Figur 3 hat den Vorteil, daß sie mit den Ausführungsformen nach den Figuren 1 und 2 kompatibel ist.

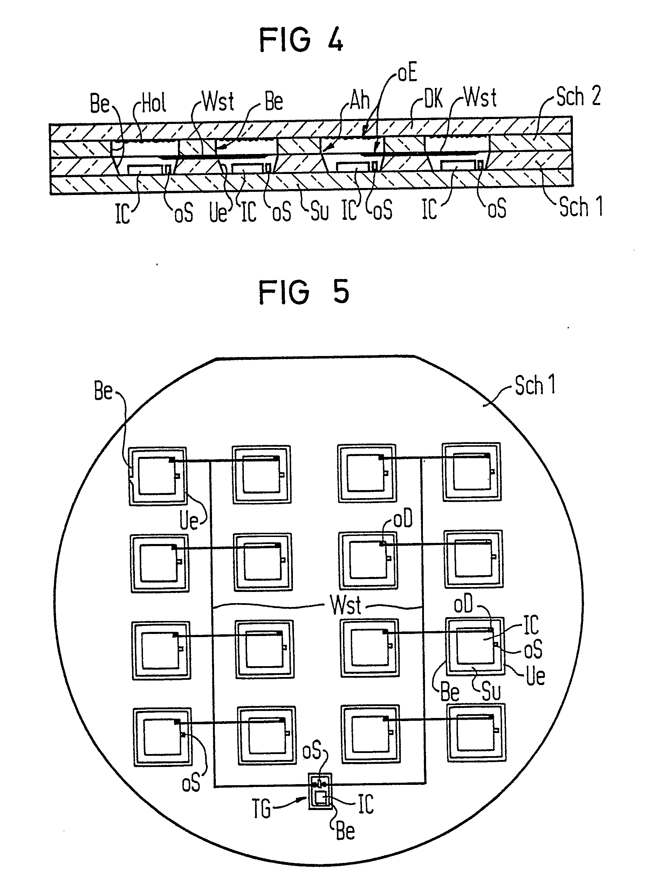

Die Figuren 4 und 5 zeigen eine Ausführungsform, bei welcher sowohl die optische Verbindung nach den Figuren 1 und 2 als auch die optische Verbindung nach der Figur 3 auf dem gleichen Substrat Su realisiert ist. Das Substrat Su besteht aus einem Siliziumwafer, auf dem eine erste Schicht Sch1 des Abstandshalters Ah fixiert ist, in der rechteckige Bereiche Be ausgespart sind. In jedem rechteckigen Bereich Be ist ein Halbleiterchip mit integriertem Schaltkreis IC und ein optischer Sender oS angeordnet. Auf dieser Schicht Sch1 ist auch eine Streifenwellenleiterstruktur Wst ausgebildet, deren Wellenleiter das von einem optischen Sender oS eines Taktgenerators TG ausgesandte Licht optischen Detektoren oD der verschiedenen integrierten Schaltkreise IC zuleitet.

In der Figur 5 ist eine Draufsicht auf die Schicht Sch1 mit der Wellenleiterstruktur Wst gezeigt. Die Seitenflächen der ausgesparten Bereiche Be der ersten Schicht Sch1 sind schräg, so daß sie Umlenkelemente Ue bilden können.

Auf der Wellenleiterstruktur Wst ist eine zweite Schicht Sch2 des Abstandshalters Ah aufgebracht, die ausgesparte Bereiche Be aufweist, die sich mit den ausgesparten Bereichen Be der ersten Schicht Sch1 decken. Auf der zweiten Schicht Sch2 ist der Deckkörper DK aufgebracht. In jedem ausgesparten Bereich Be des Abstandshalters Ah ist auf der Unterseite des Deckkörpers DK ein Lichtverteilungselement Hol angebracht, so daß in jedem Bereich eine optische Verbindung gemäß Figur 3 realisiert ist.

Die ausgesparten Bereiche Be lassen sich mit hoher Genauigkeit durch Ätzen oder anisotropes Ätzen von Siliziumwafern herstellen. Da für alle Schichten das gleiche Material verwendet ist, treten keine thermischen Spannungen auf.

Die Fixierung des Substrats Su, des Abstandshalters Ah und des Deckkörpers DK relativ zueinander kann beispielsweise durch Aneinanderkleben oder durch Verschrauben erfolgen.

## Ansprüche

1. Vorrichtung zum optischen Verbinden eines oder mehrerer optischer Sender (oS) mit einem oder mehreren optischen Detektoren (oD) eines oder mehrerer integrierter Schaltkreise (IC),
wobei der oder die integrierten Schaltkreise (IC), optischen Sender (oS) und optischen Detektoren (oD) in Form von Bausteinen auf einem Substrat (Su) fixiert sind,
wobei auf diesem Substrat (Su) ein Abstandshalter (Ah) aufgebracht ist,
wobei der Abstandshalter (Ah) von einem Deckkörper (DK) abgedeckt ist, und
wobei an dem Abstandshalter (Ah) oder/und dem Deckkörper (DK) eine optische Einrichtung (oE) zum Zuleiten des von einem optischen Sender (oS) ausgesandten Lichts zu einem oder mehreren optischen Detektoren (oD) angebracht ist.

2. Vorrichtung nach Anspruch 1, **dadurch gekennzeichnet,** daß das Substrat (Su), der Abstandshalter (Ah) und der Deckkörper (DK) aus dem gleichen Material oder aus Materialien mit im wesentlichen dem gleichen Wärmeausdehnungskoeffizienten besteht.

3. Vorrichtung nach Anspruch 1 oder 2, **dadurch gekennzeichnet,** daß das Substrat (Su), der Abstandshalter (Ah) oder/und der Deckkörper (DK) aus Silizium bestehen.

4. Vorrichtung nach einem der vorhergehenden Ansprüche, **dadurch gekennzeichnet,** daß der Abstandshalter (Ah) aus einer oder mehreren einander überlagerten Schichten (Sch; Sch1, Sch2) besteht, in der oder in denen ein oder mehrere über deren ganze Dicke sich erstreckende Bereiche (Be) ausgespart sind, in denen die auf dem Substrat (Su) fixierten Bausteine angeordnet sind.

5. Vorrichtung nach einem der vorhergehenden Ansprüche, **dadurch gekennzeichnet,** daß die optische Einrichtung (oE) zum Zuleiten von einem optischen Sender (oS) ausgesandten Lichts zu einem oder mehreren optischen Detektoren (oD) eine Wellenleiterstruktur (Wst) aufweist, die in dem Abstandshalter (Ah) oder zwischen diesem und dem Deckkörper (DK) angeordnet ist, in die das von diesem Sender (oS) ausgesandte Licht einkoppelbar ist, und aus der das diesen Detektoren (oD) zuzuleitende Licht auskoppelbar ist.

6. Vorrichtung nach Anspruch 5, **dadurch gekennzeichnet,** daß die Wellenleiterstruktur aus einem oder mehreren Streifenwellenleitern besteht.

7. Vorrichtung nach Anspruch 6, **dadurch gekennzeichnet,** daß die Streifenwellenleiter aus Glas bestehen.

8. Vorrichtung nach einem der Ansprüche 5 bis 7, **dadurch gekennzeichnet,** daß der lichtemittierende Bereich (eB) eines optischen Senders (oS), dessen Licht in eine Wellenleiterstruktur (Wst) einzukoppeln ist, gegenüber einer Stirnfläche (Stf) eines Wellenleiters dieser Struktur (Wst) angeordnet ist, durch die das von diesem Sender (oS) ausgesandte Licht in die Struktur (Wst) einkoppelbar ist.

9. Vorrichtung nach Anspruch 8, **dadurch gekennzeichnet,** daß die Wellenleiterstruktur (Wst) zwischen dem Abstandshalter (Ah) und dem Deckkörper (DK) angeordnet ist, und daß der Deckkörper (DK) im Bereich eines optischen Senders (oS), dessen lichtemittierender Bereich (eB) gegenüber einer Stirnfläche (Stf) eines Wellenleiters dieser Struktur (Wst) angeordnet ist, eine Aussparung (Asp) aufweist, in die ein über der Höhe des lichtmittierenden Bereichs (eB) liegender Teil (T) dieses optischen Senders (oS) ragt.

10. Vorrichtung nach einem der Ansprüche 5 bis 9, **dadurch gekennzeichnet,** daß das von einem optischen Sender (oS) ausgesandte Licht, das in die Wellenleiterstruktur (Wst) einzukoppeln ist, mittels einer Linse (Li) über zwei Umlenkelemente (Ue1, Ue2) auf eine Stirnfläche (Stf) eines Wellenleiters der Struktur (Wst) konzentriert ist, durch die das Licht in die Struktur (Wst) einkoppelbar ist, wobei ein Umlenkelement (Ue1) an dem Abstandshalter (Ah) und das andere Umlenkelement (Ue2) an einer über die Struktur (Wst) hinausstehenden Unterseite eines auf der Struktur (Wst) aufliegenden Körpers (DK) angebracht ist.

11. Vorrichtung nach Anspruch 10, **dadurch gekennzeichnet,** daß das eine Umlenkelement (Ue1) aus einer schrägen, reflektierenden Seitenfläche des Abstandshalters (Ah) besteht.

12. Vorrichtung nach Anspruch 10 oder 11, **dadurch gekennzeichnet,** daß das andere Umlenkelement (Ue2) aus einer schrägen Stirnfläche eines an der Unterseite des auf der Wellenleiterstruktur (Wst) aufliegenden Körpers (DK) angebrachten Wellenleiterabschnitts (Wa) ist.

13. Vorrichtung nach einem der Ansprüche 5 bis 12, **dadurch gekennzeichnet,** daß ein Detektorfenster (Df) eines optischen Detektors (oD) dem Licht aus der Wellenleiterstruktur (Wst) zuzuleiten ist, gegenüber einer Stirnfläche (Stf) eines Wellenleiters der Struktur (Wst) angeordnet ist, aus der das diesem Detektor (oD) zuzuleitende Licht auskoppelbar ist.

14. Vorrichtung nach Anspruch 13, **dadurch gekennzeichnet,** daß die Wellenleiterstruktur (Wst) zwischen dem Abstandshalter (Ah) und dem Deckkörper (DK) angeordnet ist, und daß der Deckkörper (DK) im Bereich eines optischen Detektors (oD), dessen Detektorfenster (Df) gegenüber einer Stirnfläche (Stf) eines Wellenleiters dieser Struktur (Wst) angeordnet ist, eine Aussparung (Asp) aufweist, in der ein über der Höhe des Detektorfensters (Df) liegender Teil (Tl) des optischen Detektors (oD) ragt.

15. Vorrichtung nach einem der Ansprüche 5 bis 14, **dadurch gekennzeichnet,** daß das aus einer Stirnfläche (Stf) eines Wellenleiters der Wellenleiterstruktur (Wst) ausgekoppelte Licht, das einem Detektorfenster (Df) eines optischen Detektors (oD) zuzuleiten ist, über ein Umlenkelement (Ue3) dem Detektorfenster (Df) zugeleitet ist.

16. Vorrichtung nach Anspruch 15, **dadurch gekennzeichnet,** daß das Umlenkelement (Ue3) aus einer schrägen Stirnfläche eines an einer über die Struktur (Wst) hinausstehenden Unterseite eines auf dieser Struktur (Wst) aufliegenden Körpers (DK) angebrachten Wellenleiterabschnitts (Wa) ist.

17. Vorrichtung nach einem der vorhergehenden Ansprüche, insbesondere nach einem der Ansprüche 5 bis 16, **dadurch gekennzeichnet,** daß die optische Einrichtung (oE) das von zumindest einem optischen Sender (oS) ausgesandte Licht optischen Detektoren (oD) zuleitet, die verschiedenen Bausteinen mit integrierten Schaltkreisen (IC) zugeordnet sind.

18. Vorrichtung nach Anspruch 4 und 17, **dadurch gekennzeichnet,** daß für jeden der verschiedenen Bausteine mit integrierten Schaltkreisen (IC) je ein im Abstandshalter (Ah) ausgesparter Bereich (Be) vorgesehen ist, in dem der betreffende Baustein und die ihm zugeordneten optischen Detektoren (oD) angeordnet ist.

19. Vorrichtung nach einem der vorhergehenden Ansprüche, insbesondere nach Anspruch 18, **dadurch gekennzeichnet,** daß die optische Einrichtung eine auf der Unterseite des Deckkörpers (DK) ausgebildete oder angebrachte Lichtverteilungseinrichtung (Hol) aufweist, der das von einem, einem bestimmten Baustein mit integriertem Schaltkreis (IC) zugeordneten optischen Sender (oS) ausgesandte Licht zugeleitet ist und welche dieses Licht auf optische Detektoren (oD) verteilt, die diesem Baustein zugeordnet sind.

20. Vorrichtung nach Anspruch 19, **dadurch gekennzeichnet,** daß das der Lichtverteilungseinrichtung (Hol) zugeleitete Licht dieser Einrichtung (Hol) über ein optisches Umlenkelement (Ue) zugeleitet ist.

21. Vorrichtung nach Anspruch 20, **dadurch gekennzeichnet,** daß das Umlenkelement (Ue) aus einer schrägen, reflektierenden Seitenfläche des Abstandshalters (Ah) besteht.

22. Vorrichtung nach Anspruch 18 und einem der Ansprüche 19 bis 21, **dadurch gekennzeichnet,** daß der Abstandshalter (Ah) zwei Schichten (Sch1, Sch2) aufweist, daß zwischen diesen Schichten (Sch1, Sch2) eine optische Einrichtung (oE) zum Zuleiten des von einem in einem ausgesparten Bereich (Be) des Abstandshalters (Ah) angeordneten optischen Senders (oS) ausgesandten Lichts zu einem in einem anderen ausgesparten Bereich (Be) des Abstandshalters (Ah) angeordneten optischen Detektors (oD) angeordnet ist, und daß in einem ausgesparten Bereich (Be) des Abstandshalters (Ah) an der Unterseite des Deckkörpers (DK) eine Lichtverteilungseinrichtung (Hol) ausgebildet oder angebracht ist, die das von einem in diesem ausgesparten Bereich (Be) angeordneten optischen Sender (oS) ausgesandte Licht auf optische Detektoren (oD) verteilt, die in diesem ausgesparten Bereich (Be) angeordnet sind.

# FIG 1

# FIG 2

EP 0 335 104 A2

# FIG 3

DK

Hol

Sch 2

oE

Ah

Ue

oD

oD

IC

oS

Sch 1

Su

EP 0 335 104 A2

# FIG 4

# FIG 5